# EUROPEAN PATENT APPLICATION

(11) **EP 0 966 102 A1**
(43) Date of publication of application: **22.12.1999**
(21) Application number: 98250216.3
(22) Date of filing: 17.06.1998
(51) Int. Cl.: H03J 1/00, H03J 1/02, H04H 1/00

(54) **Method and apparatus for signalling program or program source change with a characteristic acoustic mark to a program listener**

(71) Applicant: DEUTSCHE THOMSON-BRANDT GMBH, 78048 Villingen-Schwenningen (DE)
(72) Inventor: Spille, Jens, Dipl.-Ing., 30966 Hemmingen (DE)
(74) Representative: Hartnack, Wolfgang, Dipl.-Ing.

(57) **Abstract**

After changing a radio station listeners usually check whether they have selected the right or desired station by watching the mechanical position of the station keys or the frequency scale or display or the name of the tuned radio station on the receiver's display. To make changing a program or program source more convenient an acoustic mark is signalled to the program listener when he changes a program or a program source, wherein said acoustic mark is characteristic of said program or program source.

## Description

The invention relates to a method and to an apparatus for signalling an acoustic mark to a program listener.

### Background

After changing a radio station listeners usually check whether they have selected the right or desired station by watching the mechanical position of the station keys or the frequency scale or display or the name of the tuned radio station on the receiver's display.
In JP-A-06253360 a user is informed by a synthesised voice about the communication state or the location or the name of a radio station. This information takes place when a "communication disabled" status is approaching.
From telephones it is known that pressing of a dialling number key leads to a related audible tone.

### Invention

The additional checking action is inconvenient for the listener.
It is one object of the invention to disclose a method for signalling an acoustic mark to a program listener in order to make changing a program or program source more convenient. This object is achieved by the method disclosed in claim 1.

It is a further object of the invention to disclose an apparatus which utilises the inventive method. This object is achieved by the apparatus disclosed in claim 10.

According to the invention the selected station is signalled by an acoustic mark. This mark can be pre-stored in the receiver, programmed by the user or can be downloaded by the radio station via RDS (radio data system) in analog radio (FM) or via user data in digital radio systems like e.g. DAB (digital audio broadcast) and DVB (digital video broadcast). The data can be PCM, MPEG1, MPEG2, MPEG2-AAC (advanced audio coding) or CELP (code-excited linear predictive, proposed in the MPEG4 draft standard) coded data. The acoustic mark can be composed of synthetic audio data like MIDI or MPEG4 Structured Audio. Such acoustic marks can also be assigned to other operating mode keys of a receiver.
The parameters of the acoustic mark or marks like loudness level, duration and/or number of repeats can be set individually by the listener.

In principle, the inventive method is suited for signalling an acoustic mark to a program listener using audio reproduction means, wherein said acoustic mark is reproduced when the listener switches on a program or after changing a program or a program source, and wherein said acoustic mark is characteristic of said program or program source.

Advantageous additional embodiments of the inventive method are disclosed in the respective dependent claims.

In principle the inventive audio reproduction apparatus is suited for signalling an acoustic mark to a program listener and includes
- means for determining the switching on of a program or the change of a program or a program source and
- means for reproducing said acoustic mark under control of said means for determining the change of a program or a program source, wherein said acoustic mark is characteristic of said program or program source.

Advantageous additional embodiments of the inventive apparatus are disclosed in the respective dependent claim.

### Drawing

Embodiments of the invention are described with reference to the accompanying drawing, which shows in:

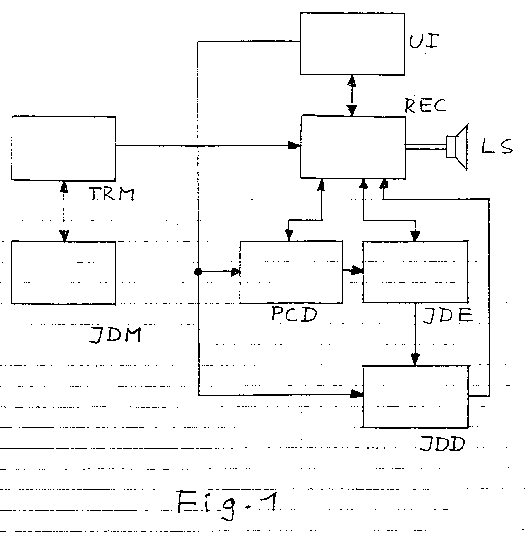

- Fig. 1: block diagram of a transmitter and of a receiver suited for acoustic mark signalling.

### Exemplary embodiments

In Fig. 1 a transmitter TRM is coupled to a jingle data memory JDM. In this memory PCM data or compressed-code data for a jingle data transmission to a receiver are stored. Such jingle data can be downloaded by transmitter TRM together with the standard analog signal broadcast (i.e. main program), e.g. FM using RDS, or with the other standard digital data broadcast, for instance MPEG in connection with DAB or DVB.

Audio or video receiver REC decodes the standard signal or data and feeds a loudspeaker LS or a couple of loudspeaker boxes. This receiver is controlled by a user interface UI which can be represented by some buttons on receiver REC or by a remote control. In connection with receiver REC or within receiver REC a program change detector PCD is operated which determines when e.g. a different type of program is broadcast on the same channel or a different program or program number store key is selected by a listener or viewer, or when a different source device like CD, VCR and DVD is selected, or when receiver REC is switched on, or when any other key on receiver REC or user interface UI is operated.

In order to determine such program or source device change, jingle data or standard data representing the prior type of program or source device can be compared with corresponding data representing the current type of program or source device to be selected.
In connection with receiver REC and program change detector PCD or within receiver REC or program change detector PCD a jingle data extractor JDE is operated which is controlled by program change detector PCD and which derives acoustic mark data from the RDS data or digital data stream data. In case of other source devices like CD, VCR and DVD, or if no jingle data are transferred from transmitter TRM, jingle data extractor JDE may store pre-programmed jingle data. The acoustic mark or jingle data collected by jingle data extractor JDE become decoded in a jingle data decoder jingle data decoder JDD, if necessary. Decoding may not be necessary in case of PCM jingle data. Jingle data decoder JDD may include for example an MPEG1, MPEG2, MPEG2-AAC, CELP, MIDI audio decoder, or an MPEG4 Structured Audio decoder. As an alternative, the jingle data may also be decoded by a decoder of such type for the standard data contained in receiver REC. Jingle data decoder JDD can be controlled by user interface UI so as to program some parameters of the acoustic mark like loudness level, duration, number of repeats. The output signal of jingle data decoder JDD is fed via receiver REC to the loudspeakers. It is also possible to influence one or more of these parameters in receiver REC itself, controlled by user interface UI.
The acoustic mark can be pre-stored in jingle data extractor JDE or receiver REC or can be programmed by a user.
The acoustic mark can be similar to or identical with the characteristic melodies, or a part thereof, some broadcasters use already in the standard data transmission e.g. at the beginning of a news broadcast, and which are well-known to the public audience. It is also possible to initiate a digital recording and storage in a memory of such melodies by the user. Such recorded data will then be further handled as pre-programmed jingle data.
It may be advantageous to transmit the jingle data not in a "real-time format" but to transmit them with a very low bit rate and to collect them in jingle data extractor JDE over a certain period of time before decoding them for the first time.
It is also possible to collect and to decode specific jingle data once and to store the decoded specific jingle data for further use in jingle data decoder JDD or receiver REC.
As a further effect different jingle data can be fed to different loudspeakers, e.g. in case of surround equipment. In case of not only signalling a program change but also the operation of other device functions this feature may be particularly useful.
The invention can also be applied to PCs (home or office computers): executing a certain software program is accompanied by an acoustic mark when starting. The jingle data can be provided e.g. via Internet.
Receiver REC can be any audio reproduction device including e.g. TVs.
The invention allows an immediate feedback for the listener. This can be particular useful for car radios.

## Claims

1. Method for signalling an acoustic mark to a program listener using audio reproduction means (REC, LS), **characterised** in that said acoustic mark is reproduced (JDE, JDD) when the listener switches on (UI, PCD) a program or after changing (UI, PCD) a program or a program source, wherein said acoustic mark is characteristic of said program or program source.

2. Method according to claim 1, wherein data related to acoustic marks corresponding to respective programs or program sources are pre-stored (JDE) in said audio reproduction means and upon selecting (UI, PCD) a specific program or program source become replayed (JDD).

3. Method according to claim 1 or 2, wherein data related to acoustic marks corresponding to respective programs or program sources are programmable by a user into (JDE) said audio reproduction means and upon selecting (UI, PCD) a specific program or program source become replayed (JDD).

4. Method according to any of claims 1 to 3, wherein data related to acoustic marks corresponding to respective programs or program sources are downloaded by a transmitter (TRM) into (JDE) said audio reproduction means and upon selecting (UI, PCD) a specific program or program source become replayed (JDD).

5. Method according to claim 4, wherein said audio reproduction means is an FM receiver (REC) and said data related to acoustic marks are transmitted using the RDS system.

6. Method according to claim 4, wherein said audio reproduction means is a digital receiver (REC) and said data related to acoustic marks are of a type like PCM or MPEG1 or MPEG2 or MPEG2-AAC or MPEG4-Structured Audio or CELP or MIDI audio data.

7. Method according to any of claims 1 to 6, wherein data related to acoustic marks are also replayed when selecting (UI) other functions of said audio reproduction means.

8. Method according to any of claims 1 to 7, wherein parameters of said acoustic marks like loudness level, duration and/or number of repeats can be set (UI) individually a user.

9. Method according to any of claims 1 to 8, wherein different acoustic marks are reproduced by different loudspeakers (LS) supplied from said audio reproduction means (REC).

10. Audio reproduction apparatus for signalling an acoustic mark to a program listener, including:
- means for determining (PCD) the switching on of a program or the change of a program or a program source;
- means for reproducing (JDE, JDD) said acoustic mark under control of said means for determining the change of a program or a program source, wherein said acoustic mark is characteristic of said program or program source.

11. Apparatus according to claim 10, wherein said means for reproducing said acoustic mark include means for storing data (JDE) related to different acoustic marks and means for decoding (JDD) said data.
